# FASCICULE DE BREVET EUROPEEN

(11) **EP 4 142 459 B1**
(45) Date de publication et mention de la délivrance du brevet: **10.12.2025**
(21) Numéro de dépôt: 22192707.2
(22) Date de dépôt: 29.08.2022
(51) Int. Cl.: H10N 60/12, H10N 60/10, H10N 60/01

(54) **TRANSISTOR À EFFET JOSEPHSON**
TRANSISTOR MIT JOSEPHSON-EFFEKT
JOSEPHSON-EFFECT TRANSISTOR

(30) Priorité: 31.08.2021 FR 2109113
(43) Date de publication de la demande: 01.03.2023
(73) Titulaire: Commissariat à l'Energie Atomique et aux Energies Alternatives, 75015 Paris (FR); Université Grenoble Alpes, 38400 Saint-Martin-d'Hères (FR)
(72) Inventeur: NEMOUCHI, Fabrice, 38054 Grenoble Cedex 09 (FR); GUSTAVO, Frederic, 38054 Grenoble Cedex 09 (FR); LEFLOCH, François, 38054 Grenoble Cedex 09 (FR); VETHAAK, Tom, 38000 Grenoble (FR)
(74) Mandataire: INNOV-GROUP

(56) Documents cités:
- FR-A1- 3 088 483
- JP-A- S59 103 389
- US-A1- 2020 287 119
- CHU W K ET AL: "Implanted noble gas atoms as diffusion markers in silicide formation", THIN SOLID FILMS, ELSEVIER, AMSTERDAM, NL, vol. 25, no. 2, 1 February 1975 (1975-02-01), pages 393 - 402, XP025703218, ISSN: 0040-6090, [retrieved on 19750201], DOI: 10.1016/0040-6090(75)90057-7

## Description

L'invention concerne un transistor à effet Josephson ainsi qu'un procédé de fabrication de ce transistor.

De tels transistors à effet Josephson sont par exemple utilisés dans le domaine des ordinateurs quantiques. Ils utilisent l'effet Josephson. En physique, l'effet Josephson se manifeste par l'apparition d'un courant non-dissipatif (super-courant) entre deux matériaux supraconducteurs séparés par une fine couche faite d'un matériau isolant ou conducteur mais non supraconducteur. L'amplitude de ce super-courant dépend de la différence de phase quantique caractérisant les deux électrodes supraconductrices.

Par exemple, la demande US2020287119A1 décrit en référence à la figure 5 un tel transistor à effet Josephson. Dans cette demande, la jonction à effet Josephson du transistor est créée en juxtaposant sur un même plan un premier réservoir supraconducteur de charges, un canal en silicium situé sous une grille et un second réservoir supraconducteur de charges.

De l'état de la technique est également connu de :
- JP59-103389A,
- EP3654394A1, et
- W.K. Chu et Al : « Implanted Noble Gas Atoms as Diffusion Markers in Silicide Formation », Thin Solid Films, vol. 25, p. 393-402, 1975.

L'invention vise à proposer un tel transistor à effet Josephson dont les performances sont améliorées. Elle a donc pour objet un transistor à effet Josephson conforme à la revendication 1.

L'invention a également pour objet un procédé de fabrication conforme à la revendication 10 du transistor à effet Josephson revendiqué.

L'invention sera mieux comprise à la lecture de la description qui va suivre, donnée uniquement à titre d'exemple non limitatif et faite en se référant aux dessins sur lesquels :
- la figure 1 est une vue schématique, en coupe verticale, d'un transistor à effet Josephson,
- la figure 2 est un vue schématique partielle, en coupe verticale, d'une source du transistor de la figure 1,
- la figure 3 est un organigramme d'un procédé de fabrication du transistor de la figure 1,
- les figures 4 à 12 sont des illustrations schématiques, en coupe verticale, de différents états de fabrication du transistor lors de la mise en œuvre du procédé de la figure 3.

Dans cette description, les définitions et conventions utilisées dans ce texte sont introduites dans un chapitre I. Ensuite, des exemples détaillés de modes de réalisation sont décrits dans un chapitre Il en référence aux figures. Dans un chapitre III, des variantes de ces modes de réalisation sont présentées. Enfin, les avantages des différents modes de réalisation sont présentés dans un chapitre IV.

### Chapitre I - Définitions et conventions :

Dans les figures, les mêmes références sont utilisées pour désigner les mêmes éléments. Dans la suite de cette description, les caractéristiques et fonctions bien connues de l'homme du métier ne sont pas décrites en détail.

Sur les figures, les épaisseurs des différentes couches ne sont pas à l'échelle pour faciliter leur lecture. Sur ces figures, les différentes couches s'étendent principalement horizontalement. Les directions horizontales sont représentées par deux directions X et Y d'un repère orthogonal XYZ. La direction Z est la direction verticale. Ici, la direction Y est perpendiculaire au plan de la feuille et n'a pas été représentée.

Les termes tels que « supérieur », « inférieur », « dessus », « dessous » et similaires sont définis par rapport à la direction Z.

L'expression "un élément qui s'étend principalement horizontalement" signifie que l'élément s'étend principalement le long d'un plan qui fait un angle avec un plan horizontale inférieur à 25° et, de préférence, inférieur à 10° ou 5°.

L'expression "un élément qui s'étend principalement verticalement" signifie que l'élément s'étend principalement le long d'un plan qui fait un angle avec la direction verticale Z inférieur à 45° et, de préférence, inférieur à 25° ou 10°.

Par la suite, l'expression "un élément réalisé en X" ou "élément en X" ou "élément de X" signifie qu'au moins 90 % de la masse de cet élément et, de préférence, au moins 95 % ou 98 % de la masse de cet élément est formé par le matériau X.

Le terme "supraconducteur" désigne un matériau dont la conductance est infinie lorsque sa température est inférieure à une température critique supérieur à 0 K et, de préférence, supérieure à 1 K ou 5 K ou 10 K. La température critique désigne la température du matériau supraconducteur en dessous de laquelle sa résistivité est nulle ou pratiquement nulle.

Le terme "non-supraconducteur" désigne un matériau qui n'est pas supraconducteur.

L'expression « matériau électriquement conducteur » désigne un matériau dont la conductivité électrique à 20 °C est supérieure à 10³ S/m et, de préférence, supérieure à 10⁵ S/m.

Un matériau électriquement isolant est un matériau dont la conductivité électrique à 20 °C est inférieure à 10⁻⁷ ou 10⁻¹¹ S/m.

Dans ce texte, le terme "siliciure de vanadium" désigne le matériau dont la formule chimique est V₃Si et non pas le matériau dont la formule chimique est VSi₂.

### Chapitre II - Exemples de modes de réalisation :

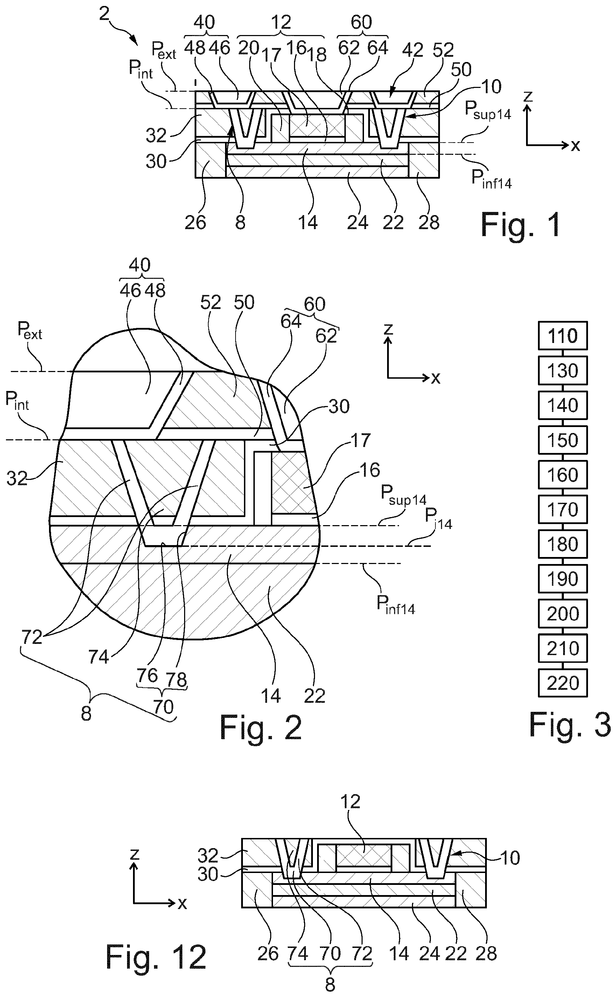

La figure 1 représente un transistor 2 à effet de champ Josephson plus connu sous l'acronyme JoFET (« Josephson Field Effect Transistor »). De tels transistors sont, par exemple, utilisés pour fabriquer des ordinateurs quantiques.

Le transistor 2 comporte une source 8, un drain 10 et une grille 12. Ici, la source 8 et le drain 10 sont disposés, le long de la direction X, respectivement, à gauche et à droite de la grille 12. Dans cet exemple de réalisation, la source 8 et le drain 10 sont structurellement identiques. Ainsi, seule la structure de la source 8 est décrite en détail plus loin en référence à la figure 2.

La grille 12 est réalisée sur la face supérieure d'une couche semi-conductrice 14. La grille 12 s'étend verticalement depuis la face supérieure de la couche 14 jusqu'à une face supérieure située du côté opposé à la couche 14.

Pour simplifier la figure 1, seuls les éléments suivants de la grille 12 ont été représentés :
- une fine couche 16 en matériau électriquement isolant directement en contact avec la face supérieure de la couche 14,
- un corps 17 en matériau semi-conducteur directement déposé sur la couche 16, et
- des espaceurs latéraux 18 et 20 disposés sur des faces verticales du corps 17 pour l'isoler électriquement de la source 8 et du drain 10.

Typiquement, en plus des éléments ci-dessus, la grille 12 peut comporter une fine couche métallique entre la couche 16 et le corps 17.

La couche 16 est par exemple réalisée en oxyde de silicium ou en silicate.

Le corps 17 s'étend jusqu'à la face supérieure de la grille 12. Le corps 17 est ici réalisé en silicium polycristallin.

Les espaceurs 18 et 20 sont réalisés dans un matériau électriquement isolant comme, par exemple, du nitrure de silicium ou un oxyde tel que de l'oxyde de silicium.

La face supérieure de la couche 14 s'étend dans un plan supérieur Pₛᵤₚ₁₄. La couche 14 comporte aussi une face inférieure qui s'étend dans un plan inférieur P_{inf14}. Le plan P_{inf14} est situé au niveau de l'interface entre la couche 14 et une couche 22 en matériau électriquement isolant située sous cette couche 14.

L'épaisseur e₁₄ de la couche 14 est égale à la distance verticale entre les plans P_{inf14} et Pₛᵤₚ₁₄. L'épaisseur e₁₄ est généralement comprise entre 5 nm et 500 nm et, de préférence entre 5 nm et 50 nm. Ici, l'épaisseur e₁₄ est comprise entre 7 nm et 30 nm.

La région de la couche 14 située sous la grille 12 et entre la source 8 et le drain 10 est dénommée « canal ». Les extrémités de ce canal sont raccordées électriquement, respectivement, à la source 8 et au drain 10. La longueur du canal dans la direction X entre ses extrémités en contact mécanique et électrique avec la source 8 et le drain 10 est typiquement supérieure à 5 nm ou 500 nm. Ici, la longueur du canal est comprise entre 20 nm et 100 nm.

La couche 22 est typiquement réalisée en oxyde de silicium. Son épaisseur est par exemple comprise entre 1 nm et 100 nm.

La couche 22 repose directement sur un support 24 qui rigidifie les différentes couches empilées dessus. Par exemple, l'épaisseur du support 24 est supérieure à 10 µm et, typiquement, supérieure à 500 µm ou 750 µm. Ici, le support 24 est réalisé en silicium tel que du silicium monocristallin, amorphe ou polycristallin. Typiquement, le support 24 et les couches 22 et 24 sont issus des différentes couches d'un substrat SOI (« Silicon On Insulator »).

Pour isoler le transistor 2 d'autres transistors fabriqués en parallèle sur le même support 24, des tranchées 26 et 28 d'isolation profonde sont réalisées autour du transistor 2. Ces tranchées 26 et 28 sont connues sous l'acronyme STI (« Shallow Trench Isolation »). Elles sont réalisées dans un matériau électriquement isolant tel que de l'oxyde de silicium ou du nitrure et de l'oxyde de silicium. La profondeur des tranchées 26 et 28 est typiquement de l'ordre de 250 nm. Ainsi, la profondeur de ces tranchées est généralement comprise entre 200 nm et 300 nm. Par "profondeur des tranchées 26 et 28" on désigne ici la plus grande dimension des tranchées 26 et 28 dans une direction perpendiculaire au plan dans lequel s'étant principalement le support 24..

La face supérieure de la couche 14 est recouverte d'une fine couche 30 en matériau électriquement isolant. Par exemple, la couche 30 est réalisée en nitrure de silicium. Son épaisseur est généralement comprise entre 2 nm et 50 nm. Cette couche 30 recouvre ici également les flancs verticaux de la grille 12 ainsi qu'une partie de sa face supérieure.

La source 8, le drain 10 et la grille 12 sont encapsulés dans une couche 32 d'encapsulation. La couche 32 présente une face supérieure qui s'étend dans un plan Pᵢₙₜ d'interconnexion. Le plan Pᵢₙₜ est horizontal et situé dans ce mode de réalisation au-dessus de la face supérieure de la grille 12 et au-dessus de la portion de la couche 30 qui recouvre une partie de la face supérieure de la grille 12. Pour simplifier les figures 1, 2 et 12, le reliquat de la couche 32 qui recouvre généralement la portion de la couche 30 située au-dessus de la grille 12 n'a pas été représenté. La couche 32 est réalisée dans un matériau électriquement isolant. Par exemple, elle est réalisée en oxyde de silicium.

Des prises 40, 42 de contact électrique sont formées sur la face supérieure de la couche 32 pour raccorder électriquement, respectivement, la source 8 à un premier potentiel électrique et le drain 10 à un second potentiel électrique. Les premier et second potentiels électriques peuvent être égaux.

Dans ce mode de réalisation, les prises 40 et 42 sont structurellement identiques et seule la structure de la prise 40 est décrite plus en détail. La prise 40 s'étend depuis le plan Pᵢₙ jusqu'à un plan extérieur Pₑₓₜ au-delà duquel sont formées les connexions électriques qui raccordent la source 8, le drain 10 et la grille 12 à des potentiels électriques. Le plan Pₑₓₜ s'étend horizontalement.

La prise 40 comporte :
- un corps 46 réalisé en matériau non-supraconducteur, et
- un revêtement extérieur 48 réalisé en matériau supraconducteur.

Le revêtement 48 raccorde électriquement la source 8 au plan Pₑₓₜ. A cet effet, le revêtement 48 recouvre les différentes faces du corps 46 qui sont situées entre les plans Pᵢₙₜ et Pₑₓₜ. Plus précisément, le revêtement 48 s'étend ici le long du plan Pᵢₙₜ depuis un emplacement où la source 8 affleure dans ce plan Pᵢₙₜ. Ainsi, le revêtement 48 est directement en contact mécanique et électrique avec la source 8. Le revêtement 48 recouvre aussi des faces latérales du corps 46 qui s'étendent principalement verticalement jusqu'au plan Pₑₓₜ. De plus, ici, le revêtement 48 empêche le matériau utilisé pour former le corps 46 de réagir avec le matériau d'encapsulation d'une couche 52. Par exemple, le revêtement 48 est réalisé en nitrure de titane (TiN). En plus d'être un matériau supraconducteur, le nitrure de titane ne réagit pas chimiquement avec le matériau de la couche 52.

Le corps 46 est, de préférence, réalisé en matériau électriquement conducteur. Ici, il est réalisé en tungstène.

Les prises 40 et 42 sont encapsulées à l'intérieur d'une couche diélectrique 52. Dans ce mode de réalisation, la couche 52 est séparée de la couche 32 par une fine couche 50 en matériau électriquement isolant. La couche 52 s'étend verticalement depuis la couche 50 jusqu'au plan Pₑₓₜ. Ici, la couche 52 est réalisée en oxyde de silicium.

Le transistor 2 comporte aussi une prise 60 de contact électrique qui permet de raccorder électriquement la grille 12 à un potentiel électrique par l'intermédiaire d'une connexion électrique située au-delà du plan Pₑₓₜ.

Ici, la structure de la prise 60 est similaire à la structure de la prise 40. Elle comporte donc notamment :
- un corps 62 réalisé en matériau non-supraconducteur, et
- un revêtement 64 réalisé en matériau supraconducteur.

Le revêtement 64 s'étend notamment le long de la face supérieure de la grille 12 pour assurer le contact mécanique et électrique entre le corps 17 et la prise 60. Le revêtement 64 traverse également les couches 50 et 52 pour affleurer dans le plan Pₑₓₜ. Par exemple, le corps 62 est réalisé en tungstène.

La figure 2 représente plus en détail la structure de la source 8. La source 8 comporte :
- un réservoir supraconducteur 70 de charges électriques,
- des flancs latéraux 72 pour raccorder électriquement le réservoir 70 à la prise 40, et
- un corps 74 logé sur le réservoir 70 et entre les flancs latéraux 72.

Le réservoir 70 est réalisé en matériau supraconducteur. Ici, il est réalisé en siliciure de vanadium. Ce réservoir 70, en combinaison avec le canal et le réservoir correspondant du drain 10, forme une jonction à effet Josephson. A cet effet, le réservoir 70 est ici situé à l'extrémité gauche du canal. De plus, le réservoir 70 est enfoncé, au moins en partie, à l'intérieur de la couche 14.

Plus précisément, le réservoir 70 comporte :
- une face inférieure 76, et
- des faces latérales enfouies à l'intérieur de la couche 14.

La face inférieure 76 s'étend dans un plan horizontal Pᵢ₁₄. Le plan Pᵢ₁₄ est situé entre les plans P_{infl4} et Pₛᵤₚ₁₄ de la couche 14. Plus précisément, la distance verticale entre les plans Pᵢ₁₄ et Pₛᵤₚ₁₄ est comprise entre 0,25e₁₄ et 0,9e₁₄ et, de préférence, entre 0,5e₁₄ et 0,75e₁₄, e₁₄ étant la distance entre les plans P_{infl4} et Pₛᵤₚ₁₄.

Les faces latérales du réservoir 70 s'étendent principalement verticalement depuis la face inférieure 76 jusqu'au plan Pₛᵤₚ₁₄. Parmi ces faces latérales, l'une d'elles, désignée par la référence numérique 78, est tournée vers une face latérale correspondante du réservoir du drain 10. Cette face latérale 78 est séparée de cette face latérale correspondante du drain 10 exclusivement par le canal formé dans la couche 14 et qui relie mécaniquement et électriquement ces deux réservoirs. L'épaisseur du réservoir 70 est typiquement comprise entre 10 nm et 400 nm et, de préférence, entre 10 nm et 100 nm ou entre 10 nm et 60 nm. L'épaisseur du réservoir 70 est égale à la plus petite distance verticale entre la face inférieure 76 et l'interface entre le réservoir 70 et le corps 74.

Les flancs latéraux 72 prolongent les faces latérales du réservoir 70 jusqu'au plan Pᵢₙₜ. A cet effet, les flancs latéraux 72 s'étendent principalement verticalement à travers les couches 30 et 32. Ainsi, l'extrémité supérieure de ces flancs latéraux 72 affleure le plan Pᵢₙₜ. Les flancs latéraux 72 sont réalisés en matériau supraconducteur. Ici, ils sont réalisés dans le même matériau supraconducteur que celui utilisé pour réaliser le réservoir 70. Ainsi, dans ce mode de réalisation, les flancs latéraux 72 et le réservoir 70 ne forme qu'un seul bloc de matière d'un seul tenant.

Le corps 74 est situé sur le réservoir 70 et entre les flancs latéraux 72. Il s'étend depuis le réservoir 70 jusqu'au plan Pᵢₙₜ. Il remplit donc complètement l'espace situé entre les flancs latéraux 72. Le corps 74 est réalisé dans un matériau non-supraconducteur. Ici, il est réalisé dans un matériau électriquement isolant. Par exemple, il est réalisé en oxyde de silicium. Le corps 74 est réalisé en matériau électriquement isolant car le raccordement électrique du réservoir 70 à la prise 40 est exclusivement réalisé par l'intermédiaire des flancs latéraux 72 en matériau supraconducteur.

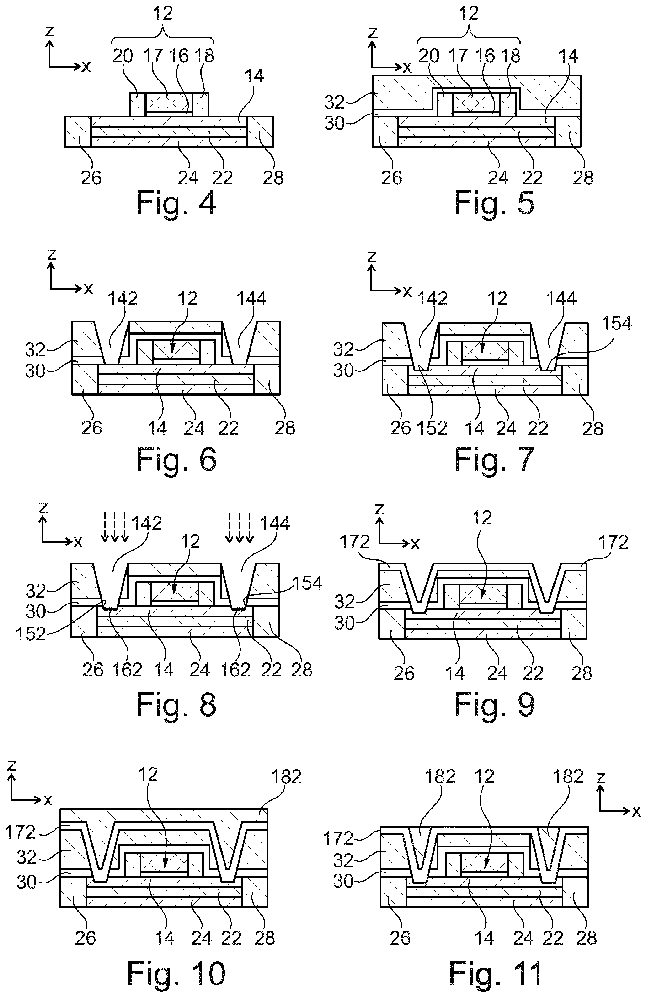

Un procédé de fabrication du transistor 2 va maintenant être décrit en référence à la figure 3 et à l'aide des figures 4 à 12.

Lors d'une étape 110, l'empilement représenté sur la figure 4 est réalisé à partir d'un substrat SOI pour former le support 24 et les couches 22 et 14. Ensuite, la grille 12 est fabriquée par gravure de différentes couches successives déposées sur la face supérieure de la couche 14. Les différentes opérations pour obtenir, à partir d'un substrat SOI, l'empilement représenté sur la figure 4, sont connues. Ainsi, l'étape 110 n'est pas décrite plus en détail.

Lors d'une étape 130, les couches 30 et 32 sont successivement déposées l'une sur l'autre pour encapsuler complètement la grille 12. Ensuite, la face supérieure de la couche 32 est polie pour obtenir l'état représenté sur la figure 5. Le polissage est arrêté avant d'atteindre la portion de la couche 30 située sur la grille 12. Ainsi, une épaisseur de la couche 32 au-dessus de la cette grille, subsiste. Par exemple, le procédé de polissage mis en œuvre est un procédé de polissage mécano-chimique connu sous l'acronyme CMP (« Chemical-Mechanical Polishing »).

Lors d'une étape 140, des trous 142 et 144 (figure 6) sont creusés de part et d'autre de la grille 12 aux emplacements où doivent être réalisés, respectivement, la source 8 et le drain 10. A ce stade, les trous 142 et 144 débouchent chacun directement sur la face supérieure de la couche 14. Pour faire cela, typiquement, il est procédé à une première opération de gravure de la couche 32 à travers un masque de gravure. Cette première opération de gravure est arrêtée lorsque la couche 30 est mise à nu. Ensuite, une seconde opération de gravure de la couche 30 est mise en œuvre pour que le fond des trous 142 et 144 débouchent directement sur la face supérieure de la couche 14. Ces première et seconde opérations de gravure sont réalisées avec des agents de gravure différents puisque les matériaux des couches 30 et 32 sont différents. A l'issue de l'étape 140, des portions de la face supérieure de la couche 14 situées au fond des trou 142 et 144 sont donc mises à nu.

Lors d'une étape 150, les portions mises à nu de la face supérieure de la couche 14 sont gravées pour creuser deux cavités 152 et 154 (Figure 7) dans la couche 14. Les cavités 152 et 154 forment les extrémités inférieures, respectivement, des trous 142 et 144. La gravure de la couche 14 est arrêtée avant d'atteindre la couche 22. Ici, cette gravure est arrêtée lorsque la profondeur de ces cavités 152, 154 est comprise entre 0,5e₁₄ et 0,75e₁₄. Le fond des cavités 152, 154 s'étend alors principalement dans le plan Pᵢ₁₄. Les faces latérales des cavités 152, 154 sont situées à l'emplacement des faces latérales des réservoirs supraconducteurs.

Lors d'une étape 160, un traitement des faces intérieures des cavités 152, 154 est réalisé pour les préparer à recevoir un dépôt de siliciure de vanadium. Ici, la préparation des faces intérieures des cavités 152, 154 consiste à incorporer des atomes d'argon 162 (figure 8) dans ces faces intérieures, ainsi qu'à nettoyer ces faces intérieures pour, notamment, les désoxyder.

Sur la figure 8, les atomes d'argon incorporés dans les faces intérieures des cavités 152, 154 sont représentés par des croix et désignés par la même référence commune 162. La majorité des atomes d'argon incorporés dans ces faces intérieures se situent à moins 10 nm et, de préférence, à moins de 5 nm de la surface de ces cavités 152, 154. Ils se situent donc à l'intérieur d'une fine couche superficielle de moins de 10 nm et, de préférence, de moins de 5 nm d'épaisseur. L'épaisseur de cette fine couche superficielle est aussi généralement supérieure à 1 nm. Avantageusement, 70 % ou 80 % ou même 90 % en masse des atomes d'argon incorporés dans la couche 14 se situent à l'intérieur de cette fine couche superficielle. La concentration d'atomes d'argon incorporés dans cette fine couche superficielle est comprise entre 1 % atomique et 10 % atomique et, de préférence, entre 2 % atomique et 5 % atomique. L'expression "X % atomique" signifie que le nombre d'atomes d'argon à l'intérieur de la fine couche superficielle représente X % du nombre total d'atomes présents dans cette couche superficielle. Dans ce texte, l'expression "incorporer des atomes d'argon dans les faces intérieures des cavités" signifie incorporer les atomes d'argon à l'intérieur de la fine couche superficielle avec une concentration comprise dans les plages de concentrations précédentes.

Ici, pour incorporer les atomes d'argon dans les faces intérieures des cavités 152, 154 et en même temps nettoyer ces faces intérieures, la partie haute du transistor en cours de fabrication est soumise à une opération de nettoyage par plasma d'argon. Lors de cette opération, la face supérieure est directement exposée à un plasma d'argon. Ce plasma comporte des ions d'argon. Le transistor et le plasma sont à des potentiels différents de sorte que les ions d'argon sont projetés sur le transistor. Des ions d'argon projetés pénètrent à l'intérieur des trous 142 et 144 et viennent percuter les faces intérieures des cavités 152, 154. Ils pénètrent alors faiblement à l'intérieur de ces faces intérieures puis se transforment en atomes d'argon. Sur la figure 8, la projection des ions d'argon sur les faces intérieures des cavités 152, 154 est représentée par des flèches verticales en pointillés.

Pour régler la quantité d'ions d'argon projetés sur les faces intérieures des cavités 152, 154, il existe principalement deux paramètres à régler pour une différence de potentiels donnée :
- la pression partielle d'argon dans le plasma, et
- la concentration d'ions d'argon dans le plasma.

La pression partielle peut être réglée en ajustant le débit de gaz d'argon entrant et sortant du réservoir contenant le plasma d'argon.

La concentration d'ions d'argon dans le plasma peut être ajustée en modifiant la puissance du courant alternatif qui circule dans une antenne qui transforme ce courant alternatif en un champ électrique alternatif présent à l'intérieur du réservoir. C'est ce champ électrique alternatif qui transforme le gaz d'argon inerte en plasma d'argon. Cette puissance est connue sous le terme de « puissance RF ». Ici, la pression partielle et la puissance RF sont réglées pour obtenir la concentration souhaitée d'atomes d'argon à l'intérieur de la fine couche superficielle dans les cavités 152, 154.

A titre d'exemple, une machine CT200 produite par la société ALLIANCE CONCEPT^{®} a été utilisée. Pour obtenir la concentration souhaitée d'atomes d'argon en surface de la couche 14 avec cette machine, la pression partielle est choisie entre 0.001 mbar (0,1 Pa) et 0.15 mbar (15 Pa) et la puissance RF est choisie entre 100 W et 400 W. Par exemple, une pression égale à 0.05 mbar (5 Pa) et une puissance RF égale à 200 W ont été utilisées.

Lors d'une étape 170, une couche 172 (Figure 9) de siliciure de vanadium est déposée sur la face supérieure du transistor en cours de fabrication. Une fois déposée, cette couche 172 recouvre les portions de la face supérieure du transistor qui s'étendent horizontalement, les parois latérales des trous 142, 144 et le fond des cavités 152, 154. Ainsi, au fond de chaque trou 142 et 144, on obtient un empilement d'une couche de siliciure de vanadium directement déposée sur la couche 14 de silicium. L'épaisseur de la couche 172 déposée est égale à l'épaisseur du réservoir 70. Dans ce mode de réalisation, son épaisseur est insuffisante pour remplir complètement les trous 142 et 144. Ainsi, à l'issue de l'étape 170, il subsiste deux creux situés aux emplacements destinés à recevoir les corps 74, respectivement, de la source 8 et du drain 10

Le dépôt de siliciure de vanadium est réalisé selon la méthode de dépôt physique en phase vapeur connue sous l'acronyme PVD ("Physical Vapor Deposition"). Par exemple, pour cela, une cible en siliciure de vanadium est bombardée avec des ions argon, ce qui arrache des atomes à la cible. Les atomes ainsi arrachés viennent ensuite se déposer sur la face supérieure du transistor en cours de fabrication. La couche 172 se dépose ainsi progressivement.

A ce stade, la couche 172 déposée est amorphe ou que partiellement cristallisée. Ainsi, à ce stade, le siliciure de vanadium n'est pas encore supraconducteur ou sa température critique est faible et peut encore être améliorée.

Lors d'une étape 180, une couche 182 (Figure 10) est déposée pour remplir complètement les creux situés aux emplacements des corps 74 de la source 8 et du drain 10. A cet effet, la couche 182 est réalisée dans le même matériau que celui du corps 74.

Lors d'une étape 190, la face supérieure de la couche 182 est polie jusqu'à atteindre la couche 172 (Figure 11). Par exemple, il s'agit d'un simple polissage mécanique. A l'issue de l'étape 190, la couche 182 subsiste uniquement à l'intérieur des trous 142, 144.

Lors d'une étape 200, un nouveau polissage est mis en œuvre pour retirer les portions de la couche 172 qui se trouvent en-dehors des trous 142, 144. Ce polissage est arrêté lorsque la portion de couche 30 située au-dessus de la grille 12 est atteinte (Figure 12). A l'issue de l'étape 200, la source 8 et le drain 10 sont obtenus.

Lors d'une étape 210, un traitement thermique est appliqué pour chauffer le siliciure de vanadium déposé et ainsi augmenter sa température critique pour, typiquement, obtenir une température critique supérieure à 10 K et, de préférence, supérieure à 15 K ou 16 K ou 17 K. Pour cela, ce traitement thermique cristallise le siliciure de vanadium déposé lors de l'étape 170.

Ce traitement thermique consiste à placer le transistor dans un four chauffé à une température prédéterminée TF comprise entre 200 °C et 1100 °C et, de préférence, comprise entre 500 °C et 900 °C.

Ensuite, le transistor est laissé dans ce four pendant une durée DF comprise entre 10 s et 15 min et, préférentiellement, comprise entre 10 s et 5 min et, encore plus préférentiellement, comprise entre 10 s et 120 s ou entre 30 s et 60 s. Typiquement, plus la température TF est élevée, plus la durée DF peut être réduite. Toutefois, une température TF trop élevée peut faire fondre d'autres couches du transistor comme le support 24 et donc l'endommager. Ainsi, un compromis acceptable doit être trouvé entre une température TF élevée et une durée DF courte. Un compromis acceptable est, par exemple, de choisir la température TF entre 500 °C et 900 °C et la durée DF entre 30 s et 60 s.

Par exemple, lors de l'étape 210, le traitement thermique est un recuit thermique rapide plus connu sous l'acronyme RTA ("Rapid Thermal Annealing").

Lors de l'étape 210, les atomes d'argon incorporés dans les faces intérieures des cavités 152, 154, empêche que siliciure de vanadium déposé réagisse avec le silicium de la couche 14 pour former du VSi₂. Le VSi₂ est un matériau non-supraconducteur et sa présence à l'interface entre le réservoir 70 et le canal en silicium dégrade les performances sur transistor fabriqué. Ici, grâce à l'étape 160, la formation de VSi₂ est supprimée ou très fortement réduite. Ceci est important, par exemple, pour obtenir une bonne jonction Josephson.

Enfin, lors d'une étape 220, les prises 40, 42 et 60 sont réalisées. Par exemple, pour cela, les couches 50 et 52 sont successivement déposées. Ensuite, des ouvertures sont réalisées dans les couches 50, 52 et 30 aux emplacements où doivent être réalisées les prises 40, 42 et 60. Une fine couche de matériau supraconducteur est alors déposée. Cette fine couche est réalisée dans le même matériau que les revêtements 48 et 64 et recouvre toutes les parois des ouvertures réalisées. Une couche de matériau non-supraconducteur est ensuite déposée. L'épaisseur de cette couche est suffisante pour remplir complètement les ouvertures réalisées. Cette couche est réalisée dans le même matériau que celui des corps 46 et 62. Enfin, la face supérieure du transistor est polie pour retirer les portions des couches déposées qui s'étendent en-dehors des ouvertures réalisées. Les prises 40, 42 et 60 sont alors obtenues.

### Chapitre III - Variantes :

### Variantes de la source et du drain :

En variante, le réservoir 70 n'est pas entièrement enfoui à l'intérieur de la couche 14. Ainsi, selon cette variante, le réservoir 70 comporte une partie inférieure située en dessous du plan Pₛᵤₚ₁₄ et une partie supérieure située au-dessus du plan Pₛᵤₚ₁₄.

Le siliciure de vanadium utilisé pour réaliser le réservoir 70 peut être remplacé par d'autres matériaux supraconducteurs. En particulier, d'autres siliciures supraconducteurs peuvent être utilisés à la place du siliciure de vanadium. Par exemple, les siliciures suivants conviennent : CoSi2 et PtSi. Bien que moins souvent utilisés, les siliciures suivants peuvent aussi convenir : PdSi, RhSi, LaSi₂ et CaSi₂. D'autres matériaux supraconducteurs qui ne sont pas des siliciures peuvent également être utilisés à la place du siliciure de vanadium comme, par exemple, le Nb₃Ge, le nitrure de titane, nitrure de tantale, l'aluminium.

Le réservoir 70 peut aussi être formé par un empilement de plusieurs matériaux supraconducteurs. Par exemple, le réservoir 70 comporte un corps en siliciure de vanadium recouvert d'un revêtement en nitrure de titane. Dans ce cas, le revêtement en nitrure de titane est interposé entre le corps en siliciure de vanadium et le silicium de la couche 14. Dans un tel cas, l'épaisseur du revêtement est petite devant l'épaisseur du corps. Par exemple, l'épaisseur de revêtement est inférieure à 5 nm ou 10 nm. Dans un tel mode de réalisation, le siliciure de vanadium est isolé mécaniquement du silicium de la couche 14 par le revêtement en nitrure de titane. L'étape 160 d'incorporation d'atomes d'argon peut alors être omise. En effet, lors de l'étape 210 de traitement thermique, le siliciure de vanadium ne réagit pas avec le silicium de la couche 14 à cause de la présence de ce revêtement en nitrure de titane.

Dans un autre mode de réalisation, le réservoir 70 n'est pas directement en contact avec le matériau de la couche 14. Par exemple, une fine couche en matériau non-supraconducteur peut être déposée sur les faces intérieures des cavités 152, 154 avant le dépôt du matériau supraconducteur. Par exemple, cette fine couche est réalisée dans un matériau semi-conducteur tel que le germanium. L'épaisseur de cette fine couche est inférieure à 10 nm ou 5 nm.

D'autres modes de réalisation de la source 8 sont possibles. Par exemple, en variante, le corps 74 est remplacé par un corps en matériau supraconducteur. De préférence, dans ce dernier cas, le corps est réalisé dans le même matériau supraconducteur que celui utilisé pour réaliser le réservoir 70. Ainsi, la source est alors uniquement formée d'un seul bloc en matériau supraconducteur. Le corps 74 peut aussi être réalisé dans un matériau diélectrique. Par contre, de préférence, le corps 74 n'est pas réalisé en matériau métallique non-supraconducteur.

Dans une autre variante, les flancs latéraux 72 sont omis et le corps 74 est remplacé par un corps en matériau électriquement conducteur et non-supraconducteur qui occupe l'emplacement des flancs latéraux 72 et l'emplacement du corps 74. Dans ce dernier cas, le réservoir 70 est raccordé électriquement à la prise 40 seulement par l'intermédiaire de ce corps en matériau électriquement conducteur et non-supraconducteur. Par exemple, dans un tel cas, le corps est réalisé en tungstène.

En variante, la structure du drain 10 n'est pas la même que la structure de la source 8. Par exemple, l'un de la source 8 et du drain 10 est réalisé selon l'une des variantes décrites dans le paragraphe précédent pour la source 8.

La source 8 et/ou le drain 10 peuvent être communs à deux transistors réalisés l'un à côté de l'autre.

La source 8, le drain 10 et la grille 12 ne sont pas nécessairement alignés les uns derrière les autres dans la direction X. Par exemple, en variante, la grille 12 comporte aussi une partie plus large, décalée dans la direction Y par rapport à l'axe sur lequel sont alignés la source 8 et le drain 10.

En variante, la face supérieure de la grille 12 s'étend dans le plan Pᵢₙₜ.

### Autres variantes du transistor :

Le corps 17 de la grille 12 peut aussi être réalisée par un empilement de métaux ou d'alliage ayant ou non des propriétés supraconductrices.

La couche 14 peut être réalisée dans un autre matériau semi-conducteur que du silicium. De préférence, la couche 14 est réalisée en matériau semi-conducteur ou dans un alliage de matériaux semi-conducteurs choisi dans le groupe constitué du silicium et du germanium ou leur alliage. Toutefois, d'autres matériaux semi-conducteurs peuvent aussi convenir, comme par exemple, un alliage InAs ou Mo₃Ge ou d'autres matériaux semi-conducteurs du groupe III - V.

Les corps 46 et 62 peuvent être réalisés dans d'autres matériaux que du tungstène. En particulier, ils peuvent aussi être réalisés dans d'autres métaux tels que de l'aluminium, du nitrure de titane ou du cuivre. Ils peuvent aussi être réalisés dans des matériaux qui ne sont pas des matériaux électriquement conducteurs. En effet, puisque les revêtements 48 et 62 sont réalisés en matériaux supraconducteurs, l'essentiel des charges électriques se propage à l'intérieur de ces revêtements et non pas à l'intérieur des corps 46 et 62. Par exemple, les corps 46 et 62 sont réalisés, en variante, en matériau électriquement isolant comme en oxyde de silicium.

Dans une autre variante, les corps 46 et/ou 62 sont aussi réalisés dans un matériau supraconducteur. Dans ce cas, les revêtements extérieurs 48 et 64 peuvent être omis.

Dans un autre mode de réalisation, les revêtements extérieurs 48 et 64 sont réalisés en matériau non-supraconducteur.

Selon l'application visée pour le transistor 2, certaines des prises 40, 42 et 60 peuvent être omises. Pour certaines applications, la prise 60 peut être commune à la grille de plusieurs transistors.

### Variantes du procédé de fabrication :

D'autres machines à plasma que celle utilisée par le déposant peuvent convenir pour incorporer les atomes d'argon en surface de la couche 14. Dans le cas où une autre machine est utilisée, celle-ci doit être réglée pour obtenir la concentration souhaitée d'atomes d'argon en surface de la couche 14. Par exemple, un tel réglage peut être déterminé expérimentalement en mesurant pour différents réglages essayés, à chaque fois la concentration d'atomes d'argon en surface de la couche 14. Par exemple, la concentration d'atomes d'argon en surface de la couche 14 peut être mesurée par spectrométrie d'émission et, en particulier, par spectrométrie de masse à plasma à couplage inductif plus connue sous l'acronyme ICP-MS (Inductively Coupled Plasma Mass Spectrometry). La concentration d'atomes d'argon peut aussi être mesurée par d'autres procédés appropriés comme la spectrométrie photoélectronique X plus connue sous l'acronyme XPS (X-Ray photoelectron spectrometry).

Avantageusement, l'opération de traitement de la face supérieure de la couche 14 avec un plasma d'argon est précédée par une opération de nettoyage de cette face supérieure avec de l'acide fluorhydrique.

D'autres méthodes sont possibles pour incorporer des atomes d'argon en surface de la couche 14 de silicium. Par exemple, dans un autre mode de réalisation, la même méthode que celle utilisée pour implanter des dopants dans un matériau semi-conducteur est utilisée pour implanter des atomes d'argon. Dans ce cas, les atomes d'argon sont d'abord ionisés. Ensuite, les ions d'argon obtenus sont accélérés par un champ électrique puis projetés sur la face supérieure de la couche 14. L'énergie des ions d'argon est réglée pour que la majorité de ces ions ne s'enfoncent pas de plus de 5 nm ou de 10 nm à l'intérieur de la couche en silicium. Ainsi à titre d'exemple, l'énergie des ions d'argon est comprise entre 5 et 15 keV. La dose nécessaire pour obtenir une concentration atomique d'argon comprise entre 1 % atomique et 10 % atomique est comprise entre 9 x 10¹⁴ et 9 x 10¹⁵ ions par centimètre carré. Dans un exemple précis la dose nécessaire à l'obtention d'une concentration atomique d'Ar de 4% atomique est de 3.6 x 10¹⁵ ions par centimètre carré sous une énergie de 10 keV. Une fois implantés dans la couche en silicium, les ions argon redeviennent des atomes neutres d'argon. De préférence, dans ce cas, après l'implantation des atomes d'argon dans la couche en silicium, une opération de nettoyage de la face supérieure de la couche en silicium est exécutée afin de finaliser sa préparation pour le dépôt du siliciure de vanadium. Ce nettoyage a notamment pour but de désoxyder la face supérieure de la couche en silicium. Par exemple, il s'agit d'un nettoyage HF, c'est-à-dire d'un nettoyage avec de l'acide fluorhydrique ou d'un nettoyage avec un plasma d'hélium ou d'argon. Lorsque le plasma d'argon est seulement utilisé pour nettoyer la face de la couche en silicium, la pression partielle et la puissance RF n'ont pas besoin d'être réglées comme décrit précédemment pour incorporer des atomes d'argon à l'intérieur de la couche 14 de silicium. Par exemple, la pression partielle d'argon et/ou la puissance RF sont beaucoup plus faibles.

Pour incorporer des atomes d'argon en surface de la couche 14 en silicium, il est aussi possible d'exposer la face supérieure de cette couche à un gaz neutre d'argon pour que des atomes d'argon soient adsorbés sur cette face supérieure. Ensuite, un traitement thermique est appliqué pour faire diffuser les atomes d'argon adsorbés à l'intérieur de la couche en silicium.

D'autres procédés que le procédé PVD sont possibles pour déposer le siliciure de vanadium sur la couche 14. Par exemple, le siliciure de vanadium peut aussi être déposé sur la couche 14 par d'autres procédés de dépôt en phase vapeur comme le procédé de dépôt chimique en phase vapeur plus connu sous l'acronyme CVD ("Chemical Vapor Deposition"). Le siliciure de vanadium peut aussi être déposé en mettant en œuvre un procédé de dépôt électrochimique.

En variante, l'étape 210 peut être exécutée à un autre moment. Par exemple, le traitement thermique peut aussi être exécuté juste après l'étape 170 et avant l'étape 180 ou avant l'étape 190 ou avant l'étape 200.

Dans le cas où un autre matériau supraconducteur est utilisé à la place du siliciure de vanadium ou dans le cas où le canal 14 est réalisé dans un autre matériau semi-conducteur que du silicium, l'étape 160 d'incorporation d'atomes d'argon peut être omise.

D'autres procédés de formation du réservoir 70 en matériau supraconducteur sont possibles. Par exemple, le procédé décrit dans la demande US2020287119A1 qui consiste à déposer du vanadium pur sur le silicium puis ensuite à le faire réagir avec le silicium pour former le siliciure de vanadium peut être utilisé. Dans ce cas, de préférence, l'épaisseur e_{Si} de la couche en silicium et l'épaisseur e_{V} de la couche en vanadium pur déposée sont choisies pour obtenir le bon rapport stœchiométrique entre le nombre d'atomes de vanadium et le nombre d'atomes de silicium pour favoriser l'apparition du siliciure de vanadium de composition V₃Si et limiter l'apparition de VSi₂. Par exemple, les épaisseurs e_{Si} et e_{V} peuvent être calculées à l'aide de la relation de proportionnalité suivante : une épaisseur de 1 nm de vanadium + une épaisseur de 0.48 nm de silicium forme une épaisseur de 1.26 nm de V₃Si. Le procédé décrit dans ce paragraphe pour former de siliciure de vanadium peut aussi être utilisé pour former d'autres matériaux supraconducteurs tel que le Nb₃Ge. Par exemple, dans le cas d'autres siliciures de formule générale MₓSi_{y}, l'épaisseur e_{Si} de la couche de silicium à faire réagir avec une couche de 1 nm d'épaisseur de l'élément M peut être déterminée à l'aide de la relation générique de proportionnalité suivante : une épaisseur de 1 nm de l'élément M + une épaisseur de e_{Si} nm de silicium forme une épaisseur de e_{MxSiy} nm du siliciure MₓSi_{y}, où :
- e_{Si} est égal à xV_{Si}/yV_{M},
- e_{MxSiy} est égal à V_{MxSiy}/V_{M},
- V_{Si} est le volume atomique occupé par un atome de silicium dans sa maille cristalline,
- V_{M} est le volume atomique occupé par un atome de l'élément M dans sa maille cristalline,
- V_{MxSiy} est le volume atomique occupé par un atome du siliciure MₓSi_{y} dans sa maille cristalline,
- x et y sont les nombres d'atomes, respectivement, de silicium et de l'élément M dans le siliciure MₓSi_{y}.

Ainsi, à l'aide de cette relation générique, il a été déterminé que :
- une épaisseur de 1 nm de palladium + une épaisseur de 1,32 nm de silicium forme une épaisseur de 1.97 nm de PdSi,
- une épaisseur de 1 nm de platine + une épaisseur de 1,35 nm de silicium forme une épaisseur de 1.98 nm de PtSi,
- une épaisseur de 1 nm de cobalt + une épaisseur de 3,64 nm de silicium forme une épaisseur de 3,52 nm de Co₂Si,
- une épaisseur de 1 nm de Tantale + une épaisseur de 2,21 nm de silicium forme une épaisseur de 2,40 nm de TaSi₂.

Le remplacement de l'incorporation d'atomes d'argon par le dépôt, sur une couche de silicium, d'un revêtement en matériau supraconducteur autre que du siliciure de vanadium afin d'empêcher le siliciure de vanadium de réagir avec le silicium lors du traitement thermique de l'étape 210, peut être mis en œuvre dans tout procédé de fabrication d'un empilement d'une couche supraconductrice de siliciure de vanadium sur une couche de silicium. En particulier ce procédé de fabrication d'un tel empilement peut être utilisé dans des procédés de fabrication d'autres composants qu'un transistor ou alors dans un procédé de fabrication d'un transistor à effet Josephson dans lequel l'étape 150 de gravure des cavités 152, 154 est omise.

### Chapitre IV - Avantages des modes de réalisation décrits :

Il a été observé que le fait d'enfoncer le réservoir 70 à l'intérieur de la couche 14 améliore les performances du transistor à effet Josephson. En particulier, cela facilite l'apparition de l'effet Josephson. La densité du courant critique à partir duquel cet effet apparaît est donc diminuée. Actuellement, cette amélioration des performances du transistor 2 est expliquée par le fait que l'enfoncement du réservoir 70 à l'intérieur de la couche 14 permet d'obtenir une face latérale 78 qui est tournée vers une face latérale correspondante du réservoir du drain. Cet enfoncement permet aussi d'augmenter la surface de l'interface entre le réservoir 70 et la couche 14. Cette augmentation de la surface d'interface est en particulier due au fait que la face inférieure 76 du réservoir est séparée du plan P_{infl4} par une épaisseur de silicium.

Le fait de faire remonter le matériau supraconducteur jusqu'au plan d'interconnexion Pᵢₙₜ permet d'augmenter la tolérance sur le positionnement des prises de contact pour la source 8 et le drain 10. En effet, puisque le matériau avec lequel la prise établit le contact électrique est un matériau supraconducteur, la surface du contact électrique entre la prise et ce matériau supraconducteur a peu d'influence sur la résistivité de ce contact électrique. Il est dès lors possible de disposer la prise 40 à cheval, comme représenté dans les précédentes figures, sur un bord de la source sans que cela ait des conséquences sur le fonctionnement du transistor.

A résistivité identique, le fait que la source comporte le corps 74 en matériau non-supraconducteur situé entre les flancs latéraux 72, permet de limiter la quantité de matériaux supraconducteurs utilisée pour fabriquer la source. En particulier, la résistivité de la source 8 est identique au cas d'une source entièrement réalisée en matériau supraconducteur.

Le fait que la prise 40 comporte un revêtement supraconducteur permet de décroître la résistivité de cette prise. De plus, le fait d'utiliser un matériau non-supraconducteur pour former le corps 46 de la prise 40 permet de limiter la quantité de matériau supraconducteur utilisée pour réaliser une telle prise.

Le fait de déposer directement du siliciure de vanadium sur la couche de silicium est avantageux par rapport au procédé qui dépose seulement du vanadium sur la couche de silicium puis qui transforme ensuite ce vanadium déposé en siliciure de vanadium à l'aide d'un traitement thermique. Tout d'abord, le procédé décrit ici permet de déposer le vanadium et le silicium dans les proportions stœchiométriques souhaitées pour obtenir le siliciure de vanadium. Il n'y a donc pas de gaspillage de matière comme, par exemple, un dépôt trop important de vanadium. Le dépôt de siliciure de vanadium est plus simple à mettre en œuvre que le dépôt de vanadium pur car le siliciure de vanadium est moins sensible à l'oxydation. Le traitement thermique appliqué lors de l'étape 210 du procédé décrit ici pour augmenter la température critique du siliciure de vanadium se déroule à une température généralement moins élevée que celle nécessaire pour faire réagir le vanadium pur déposée sur la couche de silicium afin d'obtenir du siliciure de vanadium. De plus, la durée de ce traitement thermique est plus courte. Enfin, il est plus facile de maîtriser l'épaisseur de siliciure de vanadium déposé en mettant en œuvre le procédé décrit ici que dans le cas où le siliciure de vanadium est obtenu par une réaction chimique entre du vanadium pur et une couche de silicium. En effet, cette réaction chimique consomme une partie de la couche de silicium et modifie donc l'épaisseur de la couche de vanadium.

L'utilisation d'un plasma d'argon permet, en une seule opération, de nettoyer la face supérieure de la couche 14 en silicium pour la préparer au dépôt de siliciure de vanadium et, en même temps, d'incorporer les atomes d'argon en surface de cette couche de silicium.

Le dépôt du siliciure de vanadium par le procédé PVD est simple à mettre en œuvre.

## Revendications

1. Transistor à effet Josephson, ce transistor comportant :
- un empilement comportant dans l'ordre :
- un support (24) qui s'étend principalement parallèlement à un plan appelé "plan du support",
- une couche (22) en matériau électriquement isolant,
- une couche semi-conductrice (14) directement réalisée sur la couche en matériau électriquement isolant, cette couche semi-conductrice (14) présentant :
- une face supérieure qui s'étend dans un plan supérieur (Pₛᵤₚ₁₄) parallèle au plan du support, et
- une face inférieure qui s'étend dans un plan inférieur (P_{inf14}) parallèle au plan du support, cette face inférieure étant située au niveau d'une interface entre la couche semi-conductrice (14) et la couche en matériau électriquement isolant (22),
- une grille (12) située sur la face supérieure de la couche semi-conductrice, la région de la couche semi-conductrice située sous la grille étant dénommée "canal",
- une source (8) et un drain (10) comportant chacun un réservoir (70) de charges électriques en contact électrique avec la couche semi-conductrice (14) de l'empilement, ces réservoirs (70) étant situés chacun à une extrémité respective du canal, ces réservoirs étant réalisés dans un matériau supraconducteur et formant, avec le canal, une jonction à effet Josephson,
**caractérisé en ce que** :
- chaque réservoir (70) comporte une face inférieure (76) et une face latérale (78) toutes les deux enfouies à l'intérieur de la couche semi-conductrice (14),
- la face inférieure (76) de chaque réservoir s'étend principalement dans un plan intermédiaire (Pᵢ₁₄) parallèle au plan du support, ce plan intermédiaire étant situé entre les plans inférieur (P_{inf14}) et supérieur (Pₛᵤₚ₁₄) de la couche semi-conductrice, et
- la face latérale (78) de chaque réservoir s'étend principalement perpendiculairement au plan du support, cette face latérale étant tournée vers la face latérale correspondante de l'autre réservoir et séparée de cette face latérale correspondante de l'autre réservoir par le canal.

2. Transistor selon la revendication 1, dans lequel :
- la grille (12) comporte une face supérieure tournée du côté opposé au canal, cette face supérieure affleurant un plan d'interconnexion (Pᵢₙₜ) ou étant située en-dessous de ce plan d'interconnexion, ce plan d'interconnexion étant parallèle au plan du support,
- le matériau supraconducteur du réservoir (70) d'une électrode du transistor remonte jusqu'à affleurer ce plan d'interconnexion, cette électrode du transistor étant choisie dans le groupe constitué de la source (8) et du drain (10) du transistor.

3. Transistor selon la revendication 2, dans lequel le transistor comporte une prise (40, 42) de contact électrique pour raccorder électriquement cette électrode à un potentiel électrique, cette prise de contact étant formée sur le plan d'interconnexion et directement en contact mécanique et électrique avec le matériau supraconducteur qui affleure le plan d'interconnexion.

4. Transistor selon la revendication 2 ou 3, dans lequel l'électrode du transistor comporte :
- des flancs latéraux (72) qui s'étendent depuis le réservoir (70) de cette électrode jusqu'au plan d'interconnexion, ces flancs latéraux étant situés dans le prolongement de faces latérales du réservoir et ne formant qu'un seul bloc en matériau supraconducteur avec ce réservoir, et
- un corps (74) en matériau non-supraconducteur situé sur le réservoir et entre ces flancs latéraux.

5. Transistor selon la revendication 3, dans lequel la prise (40, 42) de contact comporte :
- un corps (46) en matériau non-supraconducteur, et
- un revêtement (48) extérieur en matériau supraconducteur qui enrobe au moins une partie du corps (46) en matériau non-supraconducteur, ce revêtement s'étendant depuis le matériau supraconducteur de l'électrode qui affleure le plan d'interconnexion jusqu'à une face supérieure de la prise de contact.

6. Transistor selon l'une quelconque des revendications précédentes, dans lequel la distance entre le plan intermédiaire (Pᵢ₁₄) et le plan supérieur (Pₛᵤₚ₁₄) est comprise entre 0,25e₁₄ et 0,9e₁₄, où e₁₄ est égal à la distance entre les plans supérieur (Pₛᵤₚ₁₄) et inférieur (P_{inf14}).

7. Transistor selon la revendication 6, dans lequel la distance entre le plan intermédiaire et le plan supérieur est comprise entre 0,5e₁₄ et 0,75e₁₄.

8. Transistor selon la revendication 6 ou 7, dans lequel, la distance e₁₄ est comprise entre 7 nm et 30 nm.

9. Transistor selon l'une quelconque des revendications précédentes, dans lequel la couche semi-conductrice (14) est réalisée dans un matériau semi-conducteur ou dans un alliage de matériaux semi-conducteurs choisi dans le groupe constitué du silicium et du germanium.

10. Procédé de fabrication d'un transistor à effet Josephson, ce procédé comportant :
- la réalisation (110) d'un empilement comportant dans l'ordre :
- un support qui s'étend principalement parallèlement à un plan appelé "plan du support",
- une couche en matériau électriquement isolant,
- une couche semi-conductrice directement réalisée sur la couche en matériau électriquement isolant, cette couche semi-conductrice présentant :
- une face supérieure qui s'étend dans un plan supérieur parallèle au plan du support, et
- une face inférieure qui s'étend dans un plan inférieur parallèle au plan du support, cette face inférieure étant située au niveau d'une interface entre la couche semi-conductrice et la couche en matériau électriquement isolant,
- une grille située sur la face supérieure de la couche semi-conductrice, la région de la couche semi-conductrice située sous la grille étant dénommée "canal",
- la réalisation (130-210) d'une source et d'un drain comportant chacun un réservoir de charges électriques en contact électrique avec la couche semi-conductrice de l'empilement, ces réservoirs étant situés chacun à une extrémité respective du canal, ces réservoirs étant réalisés dans un matériau supraconducteur et formant avec le canal une jonction à effet Josephson,
**caractérisé en ce que** la réalisation de la source et du drain comporte :
- la gravure (150) dans la couche semi-conductrice, à chaque extrémité du canal, d'une première et d'une seconde cavités, chacune des première et seconde cavités présentant :
- un fond qui s'étend principalement dans un plan intermédiaire parallèle au plan du support, ce plan intermédiaire étant situé entre les plans inférieur et supérieur de la couche semi-conductrice, et
- des parois latérales qui s'étendent principalement perpendiculairement au plan du support et l'une de ces parois latérales étant tournée vers une paroi latérale correspondante de l'autre cavité et séparée de cette paroi latérale correspondante de l'autre cavité par le canal,
- le dépôt (170) d'un matériau supraconducteur sur le fond et les parois latérales des première et seconde cavités pour obtenir les réservoirs du drain et de la source.

11. Procédé selon la revendication 10, dans lequel :
- lors de la réalisation de l'empilement, la couche semi-conductrice est réalisée en silicium,
- lors du dépôt (170) du matériau supraconducteur, le matériau supraconducteur déposé est du siliciure de vanadium,
- avant le dépôt du siliciure de vanadium, des atomes d'argon sont incorporés (160) dans le fond et les parois latérales des première et seconde cavités, puis
- un traitement thermique (210) est appliqué pour augmenter la température critique du siliciure de vanadium déposé.

12. Procédé selon la revendication 11, dans lequel l'incorporation d'atomes d'argon génère, à l'intérieur de la couche de silicium, une fine couche superficielle à l'intérieur de laquelle la concentration d'atomes d'argon est comprise entre 1 % atomique et 10 % atomique.

## Patentansprüche

1. Transistor mit Josephson-Effekt, wobei dieser Transistor umfasst:
- einen Stapel, der in der Reihenfolge umfasst:
- einen Träger (24), der sich hauptsächlich parallel zu einer "Ebene des Trägers" genannten Ebene erstreckt,
- eine Schicht (22) aus elektrisch isolierendem Material,
- eine Halbleiterschicht (14), die direkt auf der Schicht aus elektrisch isolierendem Material ausgeführt ist, wobei diese Halbleiterschicht (14) aufweist:
- eine Oberseite, die sich in einer oberen Ebene (Pₛᵤₚ₁₄) parallel zu der Ebene des Trägers erstreckt, und
- eine Unterseite, die sich in einer unteren Ebene (P_{inf14}) parallel zu der Ebene des Trägers erstreckt, wobei diese Unterseite an einer Grenzfläche zwischen der Halbleiterschicht (14) und der Schicht aus elektrisch isolierendem Material (22) gelegen ist,
- ein Gate (12), das auf der Oberseite der Halbleiterschicht gelegen ist, wobei die unter dem Gate gelegene Region der Halbleiterschicht als "Kanal" bezeichnet wird,
- eine Source (8) und ein Drain (10), die jeweils ein Reservoir (70) mit elektrischen Ladungen in elektrischem Kontakt mit der Halbleiterschicht (14) des Stapels umfassen, wobei diese Reservoirs (70) jeweils an einem jeweiligen Ende des Kanals gelegen sind, wobei diese Reservoirs aus einem supraleitenden Material ausgeführt sind und mit dem Kanal einen Übergang mit Josephson-Effekt bilden,
**dadurch gekennzeichnet, dass**:
- jedes Reservoir (70) eine Unterseite (76) und eine seitliche Seite (78) umfasst, die alle beide in der Halbleiterschicht (14) vergraben sind,
- die Unterseite (76) jedes Reservoirs sich hauptsächlich in einer Zwischenebene (Pᵢ₁₄) parallel zu der Ebene des Trägers erstreckt, wobei diese Zwischenebene zwischen der unteren Ebene (P_{inf14}) und der oberen Ebene (Pₛᵤₚ₁₄) der Halbleiterschicht gelegen ist, und
- die seitliche Seite (78) jedes Reservoirs sich hauptsächlich senkrecht zu der Ebene des Trägers erstreckt, wobei diese seitliche Seite zu der entsprechenden seitlichen Seite des anderen Reservoirs gewandt ist und von dieser entsprechenden seitlichen Seite des anderen Reservoirs durch den Kanal getrennt ist.

2. Transistor nach Anspruch 1, wobei:
- das Gate (12) eine Oberseite umfasst, die zu der zum Kanal entgegengesetzten Seite gewandt ist, wobei diese Oberseite bündig mit einer Verbindungsebene (Pᵢₙₜ) ist oder unterhalb dieser Verbindungsebene gelegen ist, wobei diese Verbindungsebene parallel zu der Ebene des Trägers ist,
- das supraleitende Material des Reservoirs (70) einer Elektrode des Transistors aufsteigt, bis es bündig mit dieser Verbindungsebene ist, wobei diese Elektrode des Transistors aus der aus der Source (8) und dem Drain (10) des Transistors bestehenden Gruppe gewählt ist.

3. Transistor nach Anspruch 2, wobei der Transistor einen elektrischen Kontaktanschluss (40, 42) umfasst, um diese Elektrode elektrisch an ein elektrisches Potential anzuschließen, wobei dieser Kontaktanschluss auf der Verbindungsebene und direkt in mechanischem und elektrischem Kontakt mit dem supraleitenden Material gebildet ist, das bündig mit der Verbindungsebene ist.

4. Transistor nach Anspruch 2 oder 3, wobei die Elektrode des Transistors umfasst:
- seitliche Flanken (72), die sich von dem Reservoir (70) dieser Elektrode aus bis zu der Verbindungsebene erstrecken, wobei diese seitlichen Flanken in der Verlängerung von seitlichen Seiten des Reservoirs gelegen sind und nur einen einzigen Block aus supraleitendem Material mit diesem Reservoir bilden, und
- einen Körper (74) aus nicht supraleitendem Material, der auf dem Reservoir und zwischen diesen seitlichen Flanken gelegen ist.

5. Transistor nach Anspruch 3, wobei der Kontaktanschluss (40, 42) umfasst:
- einen Körper (46) aus nicht supraleitendem Material, und
- einen äußeren Überzug (48) aus supraleitendem Material, der mindestens einen Teil des Körpers (46) aus nicht supraleitendem Material umhüllt, wobei sich dieser Überzug von dem supraleitenden Material der Elektrode aus, das bündig mit der Verbindungsebene ist, bis zu einer Oberseite des Kontaktanschlusses erstreckt.

6. Transistor nach einem der vorhergehenden Ansprüche, wobei der Abstand zwischen der Verbindungsebene (Pᵢ₁₄) und der oberen Ebene (Pₛᵤₚ₁₄) zwischen 0,25e₁₄ und 0,9e₁₄ beträgt, wobei e₁₄ gleich dem Abstand zwischen der oberen Ebene (Pₛᵤₚ₁₄) und der unteren Ebene (P_{inf14}) ist.

7. Transistor nach Anspruch 6, wobei der Abstand zwischen der Zwischenebene und der oberen Ebene zwischen 0,5e₁₄ und 0,75e₁₄ beträgt.

8. Transistor nach Anspruch 6 oder 7, wobei der Abstand e₁₄ zwischen 7 nm und 30 nm beträgt.

9. Transistor nach einem der vorhergehenden Ansprüche, wobei die Halbleiterschicht (14) aus einem Halbleitermaterial ausgeführt ist oder aus einer Legierung aus Halbleitermaterialien, die aus der aus Silicium und Germanium bestehenden Gruppe gewählt ist.

10. Verfahren zur Herstellung eines Transistors mit Josephson-Effekt, wobei dieses Verfahren umfasst:
- das Ausführen (110) eines Stapels, der in der Reihenfolge umfasst:
- einen Träger, der sich hauptsächlich parallel zu einer "Ebene des Trägers" genannten Ebene erstreckt,
- eine Schicht aus elektrisch isolierendem Material,
- eine Halbleiterschicht, die direkt auf der Schicht aus elektrisch isolierendem Material ausgeführt ist, wobei diese Halbleiterschicht aufweist:
- eine Oberseite, die sich in einer oberen Ebene parallel zu der Ebene des Trägers erstreckt, und
- eine Unterseite, die sich in einer unteren Ebene parallel zu der Ebene des Trägers erstreckt, wobei diese Unterseite an einer Grenzfläche zwischen der Halbleiterschicht und der Schicht aus elektrisch isolierendem Material gelegen ist,
- ein Gate, das auf der Oberseite der Halbleiterschicht gelegen ist, wobei die unter dem Gate gelegene Region der Halbleiterschicht als "Kanal" bezeichnet wird,
- das Ausführen (130-210) einer Source und eines Drains, die jeweils ein Reservoir mit elektrischen Ladungen in elektrischem Kontakt mit der Halbleiterschicht des Stapels umfassen, wobei diese Reservoirs jeweils an einem jeweiligen Ende des Kanals gelegen sind, wobei diese Reservoirs aus einem supraleitenden Material ausgeführt sind und mit dem Kanal einen Übergang mit Josephson-Effekt bilden,
**dadurch gekennzeichnet, dass** das Ausführen der Source und des Drains umfasst:
- das Ätzen (150) in der Halbleiterschicht, an jedem Ende des Kanals, einer ersten und einer zweiten Kavität, wobei jede dieser ersten und zweiten Kavitäten aufweist;
- einen Boden, der sich hauptsächlich in einer Zwischenebene parallel zu der Ebene des Trägers erstreckt, wobei diese Zwischenebene zwischen der unteren Ebene und der oberen Ebene der Halbleiterschicht gelegen ist, und
- Seitenwände, die sich hauptsächlich senkrecht zu der Ebene des Trägers erstrecken, und wobei eine dieser Seitenwände zu einer entsprechenden Seitenwand der anderen Kavität gewandt ist und von dieser entsprechenden Seitenwand der anderen Kavität durch den Kanal getrennt ist,
- das Abscheiden (170) eines supraleitenden Materials auf dem Boden und den Seitenwänden der ersten und zweiten Kavitäten, um die Reservoirs des Drains und der Source zu erhalten.

11. Verfahren nach Anspruch 10, wobei:
- bei dem Ausführen des Stapels die Halbleiterschicht aus Silicium ausgeführt wird,
- bei dem Abscheiden (170) des supraleitenden Materials das abgeschiedene supraleitende Material Vanadiumsilizid ist,
- vor dem Abscheiden des Vanadiumsilizids Argonatome in den Boden und die Seitenwände der ersten und zweiten Hohlräume eingearbeitet (160) werden, dann
- eine thermische Behandlung (210) angewandt wird, um die kritische Temperatur des abgeschiedenen Vanadiumsilizids zu erhöhen.

12. Verfahren nach Anspruch 11, bei dem das Einarbeiten von Argonatomen in der Siliziumschicht eine dünne oberflächliche Schicht erzeugt, in der die Argonatomkonzentration zwischen 1 Atom-% und 10 Atom-% beträgt.

## Claims

1. Josephson transistor, this transistor comprising:
- a stack comprising, in this order:
- a support (24) that extends mainly parallel to a plane called "plane of the support",
- a layer (22) of electrically insulating material,
- a semiconductor layer (14) produced directly on the layer of electrically insulating material, this semiconductor layer (14) having:
- an upper face that extends in an upper plane (Pₛᵤₚ₁₄) parallel to the plane of the support, and
- a lower face that extends in a lower plane (P_{inf14}) parallel to the plane of the support, this lower face being located level with an interface between the semiconductor layer (14) and the layer of electrically insulating material (22),
- a gate (12) located on the upper face of the semiconductor layer, the region of the semiconductor layer located under the gate being called "channel",
- a source (8) and a drain (10) each comprising an electric charge reservoir (70) in electrical contact with the semiconductor layer (14) of the stack, these reservoirs (70) each being located at a respective end of the channel, these reservoirs being made from a superconducting material and forming, with the channel, a Josephson junction,
**characterized in that**:
- each reservoir (70) comprises a lower face (76) and a side face (78) both buried inside the semiconductor layer (14),
- the lower face (76) of each reservoir extends mainly in an intermediate plane (Pᵢ₁₄) parallel to the plane of the support, this intermediate plane being located between the lower plane (P_{inf14}) and the upper plane (Pₛᵤₚ₁₄) of the semiconductor layer, and
- the side face (78) of each reservoir extends mainly perpendicular to the plane of the support, this side face facing the corresponding side face of the other reservoir and being separated from this corresponding side face of the other reservoir by the channel.

2. Transistor according to Claim 1, wherein:
- the gate (12) comprises an upper face facing the side opposite the channel, this upper face being located flush with an interconnection plane (Pᵢₙₜ) or being located below this interconnection plane, this interconnection plane being parallel to the plane of the support,
- the superconducting material of the reservoir (70) of an electrode of the transistor rises until being located flush with this interconnection plane, this electrode of the transistor being chosen from the group consisting of the source (8) and the drain (10) of the transistor.

3. Transistor according to Claim 2, wherein the transistor comprises an electrical contact outlet (40, 42) for electrically connecting this electrode to an electrical potential, this contact outlet being formed on the interconnection plane and in direct mechanical and electrical contact with the superconducting material that is located flush with the interconnection plane.

4. Transistor according to Claim 2 or 3, wherein the electrode of the transistor comprises:
- side flanks (72) that extend from the reservoir (70) of this electrode to the interconnection plane, these side flanks being located in the extension of side faces of the reservoir and forming just a single block of superconducting material with this reservoir, and
- a body (74) made of non-superconducting material, located on the reservoir and between these side flanks.

5. Transistor according to Claim 3, wherein the contact outlet (40, 42) comprises:
- a body (46) made of non-superconducting material, and
- an outer coating (48) made of superconducting material that at least partially surrounds the body (46) made of non-superconducting material, this coating extending from the superconducting material of the electrode that is located flush with the interconnection plane to an upper face of the contact outlet.

6. Transistor according to any one of the preceding claims, wherein the distance between the intermediate plane (Pᵢ₁₄) and the upper plane (Pₛᵤₚ₁₄) is between 0.25e₁₄ and 0.9e₁₄, where e₁₄ is equal to the distance between the upper plane (Pₛᵤₚ₁₄) and the lower plane (P_{inf14}).

7. Transistor according to Claim 6, wherein the distance between the intermediate plane and the upper plane is between 0.5e₁₄ and 0.75e₁₄.

8. Transistor according to Claim 6 or 7, wherein the distance e₁₄ is between 7 nm and 30 nm.

9. Transistor according to any one of the preceding claims, wherein the semiconductor layer (14) is made from a semiconductor material or from an alloy of semiconductor materials chosen from the group consisting of silicon and germanium.

10. Method for fabricating a Josephson transistor, this method comprising:
- producing (110) a stack comprising, in this order:
- a support that extends mainly parallel to a plane called "plane of the support",
- a layer of electrically insulating material,
- a semiconductor layer produced directly on the layer of electrically insulating material, this semiconductor layer having:
- an upper face that extends in an upper plane parallel to the plane of the support, and
- a lower face that extends in a lower plane parallel to the plane of the support, this lower face being located level with an interface between the semiconductor layer and the layer of electrically insulating material,
- a gate located on the upper face of the semiconductor layer, the region of the semiconductor layer located under the gate being called "channel",
- producing (130-210) a source and a drain each comprising an electric charge reservoir in electrical contact with the semiconductor layer of the stack, these reservoirs each being located at a respective end of the channel, these reservoirs being made from a superconducting material and forming, with the channel, a Josephson junction,
**characterized in that** producing the source and the drain comprises:
- etching (150), into the semiconductor layer, at each end of the channel, a first and a second cavity, each of the first and second cavities having:
- a bottom that extends mainly in an intermediate plane parallel to the plane of the support, this intermediate plane being located between the lower plane and the upper plane of the semiconductor layer, and
- side walls that extend mainly perpendicular to the plane of the support and one of these side walls facing a corresponding side wall of the other cavity and being separated from this corresponding side wall of the other cavity by the channel,
- depositing (170) a superconducting material on the bottom and the side walls of the first and second cavities to obtain the reservoirs of the drain and of the source.

11. Method according to Claim 10, wherein:
- when producing the stack, the semiconductor layer is made of silicon,
- when depositing (170) the superconducting material, the deposited superconducting material is vanadium silicide,
- before the vanadium silicide is deposited, argon atoms are incorporated (160) into the bottom and the side walls of the first and second cavities, and then
- a heat treatment (210) is applied to increase the critical temperature of the deposited vanadium silicide.

12. Method according to Claim 11, wherein the incorporation of argon atoms generates, inside the silicon layer, a thin surface layer inside which the concentration of argon atoms is between 1 atom% and 10 atom%.
